# FASCICULE DE BREVET EUROPEEN

(11) **EP 0 926 503 B1**
(45) Date de publication et mention de la délivrance du brevet: **16.06.2004**
(21) Numéro de dépôt: 98403259.9
(22) Date de dépôt: 22.12.1998
(51) Int. Cl.: G01R 31/00, H02J 7/16

(54) **Regulateur d'alternateur polyphasé de véhicule automobile**
Mehrphasiger Generatorregler für Kraftfahrzeug
Poly-phase alternator regulator for an automobile

(30) Priorité: 24.12.1997 FR 9716495
(43) Date de publication de la demande: 30.06.1999
(73) Titulaire: VALEO EQUIPEMENTS ELECTRIQUES MOTEUR, 94000 Créteil (FR)
(72) Inventeur: Pierret, Jean-Marie, 75012 Paris (FR)
(74) Mandataire: Martin, Jean-Jacques

(56) Documents cités:
- FR-A- 2 678 070
- US-A- 4 369 407
- US-A- 5 471 135

## Description

La présente invention est relative aux régulateurs d'alternateur de véhicule automobile.

Les nouveaux régulateurs de tension batterie comportent des fonctions qui se déroulent en plusieurs secondes (temporisation au démarrage, charge progressive, par exemple). Ces durées sont inacceptables lorsque le régulateur est testé pendant et après sa fabrication. Il est donc nécessaire d'accélérer le déroulement de ces fonctions pendant le temps de test.

Une solution classique est de provoquer un fonctionnement en mode accéléré en utilisant au moins une entrée supplémentaire sur le régulateur.

Cette solution présente toutefois l'inconvénient d'imposer une plus grande complexité mécanique et un coût plus important, puisqu'elle nécessite au moins une broche supplémentaire.

Un but de l'invention est donc dé proposer un régulateur sur lequel il est possible de déclencher le fonctionnement du régulateur en mode accéléré pour réduire le temps de test, sans que ledit régulateur ne comporte d'entrée spécialement dédiée à cette fonction particulière et sans que les autres fonctions dudit régulateur (auto-amorçage bas niveau par exemple) ne soit affectées.

A cet effet, l'invention propose un régulateur d'alternateur polyphasé de véhicule automobile comportant d'une part des moyens pour détecter une tension entre des bornes de phase destinées à recevoir des potentiels de phase dudit alternateur et d'autre part des moyens pour détecter un signal de déclenchement d'un fonctionnement en mode accéléré, caractérisé en ce que les moyens de détection du signal de déclenchement comportent des moyens pour détecter un niveau particulier de potentiel ou d'intensité de courant sur au moins une borne de phase, ainsi que des moyens pour déclencher un fonctionnement en mode accéléré lorsque ce niveau de potentiel ou d'intensité de courant est détecté et en ce que les moyens pour la détection d'une tension entre les bornes de phase sont aptes à détecter ladite tension avec ce niveau d'intensité ou de potentiel sur la borne de phase précitée.

Ce régulateur est avantageusement complété par les différentes caractéristiques suivantes prises seules ou selon toutes leurs combinaisons techniquement possibles :
- les moyens de détection du signal de déclenchement comportent des moyens pour détecter un niveau de tension particulier sur les crêtes d'au moins un potentiel reçu sur une borne de phase ;
- lesdits moyens de détection comportent des moyens pour détecter que les crêtes des alternances négatives dudit potentiel sont inférieures à un seuil de potentiel en dessous du potentiel de masse.
- ledit seuil de potentiel est de l'ordre de 10 volts en dessous du potentiel de masse.
- lesdits moyens de détection comportent des moyens pour détecter que les crêtes des alternances positives d'un potentiel reçu sur une borne de phase sont supérieures à un seuil au-dessus de la tension de la batterie.

De façon particulièrement avantageuse, les moyens de détection d'une tension entre des bornes de phases comportent un montage de transistors formant miroir de courant dont deux branches sont alimentées par des montages de transistors formant sources de courant d'intensités différentes, l'un des transistors de ces montages formant sources de courant se limitant à une valeur de courant prédéterminée lorsqu'une différence de potentiel apparaît entre les deux bornes de phase, cette limitation entraînant le changement de niveau d'une sortie logique.

Notamment, dans un mode de réalisation préférée, le régulateur comporte préférentiellement deux sorties logiques et lesdits montages de transistors formant miroir et source de courant sont dédoublés pour entraîner le changement de niveau de l'une ou l'autre desdites sorties logiques selon le sens de la différence de potentiel entre les bornes de phase.

De tels moyens de détection permettent de détecter une tension entre les bornes de phases indépendamment du potentiel sur ces bornes, ce que ne permettent pas les moyens de détection décrits dans les brevets FR-2.343.255 et FR-2.730.359.

Ils permettent en outre une précision de détection (niveau de détection de l'ordre de 200 mV) bien meilleure que celle que permet le montage décrit dans le brevet français publié sous le numéro 2.678.070.

Egalement, ils permettent une détection qui présente peu de dérive en température.

Dans un mode de réalisation préféré, le régulateur comporte des moyens pour modifier le niveau de détection de la tension entre les bornes de phase lorsque le potentiel reçu sur lesdites bornes est supérieur à une valeur donnée.

Avantageusement encore, les moyens pour déclencher le fonctionnement en mode accéléré comportent un circuit de temporisation monté en sortie des moyens de détection du niveau de tension ou d'intensité de courant.

D'autres caractéristiques et avantages de l'invention ressortiront encore de la description. Cette description est purement illustrative et non limitative et doit être lue en regard des dessins annexés sur lesquels :
- La figure 1 est une représentation schématique d'un circuit d'alternateur triphasé conventionnel.
- La figure 2 est un schéma d'un montage possible pour les moyens de détection de la tension entre des bornes de phase d'un régulateur conforme à un mode de réalisation possible de l'invention.
- La figure 3 illustre un exemple de signaux en entrée et en sortie du montage de la figure 2 lorsque l'alternateur entre en rotation.
- La figure 4 est un graphe sur lequel on a porté les signaux de phase en sortie des enroulements d'induit de l'alternateur, lorsque le régulateur est sous charge.
- Les figures 5 et 6 sont des schémas de montage possibles pour les moyens de détection du niveau de tension déclenchant le fonctionnement en mode accéléré pour le régulateur de la figure 1.

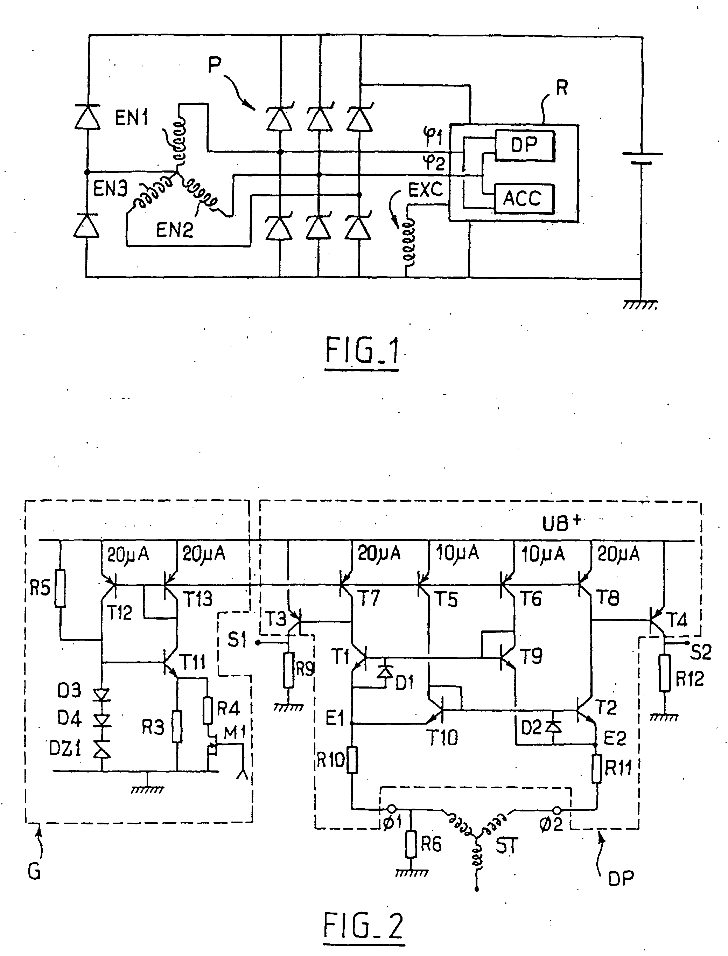

On a représenté schématiquement sur la figure 1 un circuit d'alternateur triphasé conventionnel. Ce circuit comporte notamment trois enroulements d'induit d'alternateur EN1, EN2, EN3 montés en étoile, un pont redresseur P constitué de trois paires de diodes et un régulateur R présentant deux entrées de phase φ1 et φ2 recevant deux des trois potentiels de phase des enroulements d'induit EN1, EN2, EN3.

Ce régulateur R comporte un circuit DP pour détecter l'apparition d'une tension entre les deux bornes de phase φ1 et φ2 lors de la mise en rotation de l'alternateur et déclencher la régulation de la tension de la batterie lorsque cette mise en rotation est ainsi détectée.

Il comporte également un circuit ACC qui détecte sur au moins une des bornes du régulateur un niveau de signal qui correspond à celui destiné à déclencher le fonctionnement en mode accéléré du régulateur.

Pour tester le régulateur, notamment à l'issue de sa fabrication et avant qu'il ne soit monté sur l'alternateur, on applique sur les bornes de phase φ1 et φ2 des signaux simulant des signaux de phase susceptibles d'être générés par des enroulements d'induit.

Pour la mise en oeuvre d'un tel test, le mode de fonctionnement accéléré du régulateur est déclenché par la détection par le circuit ACC d'un niveau de signal particulier, distinct du niveau de signal en fonctionnement normal, sur l'une des bornes du régulateur.

Dans un mode de réalisation particulièrement avantageux, le mode de fonctionnement accéléré peut être provoqué par la détection de la présence de crêtes de potentiel fortement négatives (de l'ordre de 10 volts en dessous du potentiel de masse par exemple) sur l'une ou l'autre des bornes de phase φ1 et φ2 du régulateur R. De tels niveaux de crêtes de tension négatifs n'existent pas en fonctionnement normal, lorsque le régulateur est fixé sur l'alternateur, car l'amplitude des signaux phases est limitée par les diodes du pont redresseur.

Le circuit de détection DP est choisi pour permettre une détection de l'apparition d'une tension entre les bornes de phase φ1 et φ2 indépendamment du niveau de potentiel sur l'une et l'autre de ces deux phases. Un exemple de circuit de détection DP capable de fonctionner avec des valeurs de crêtes fortement négatives ( - 10 volts par rapport au potentiel de masse) est illustré sur la figure 2.

Ce circuit comprend deux miroirs de courant montés entre les bornes φ1 et φ2 et constitués l'un par deux transistors NPN T1, T10, l'autre par deux transistors NPN T2, T9.

Plus particulièrement, la borne φ1 est reliée via une résistance R10 à l'émetteur (point E1) du transistor T1 et à l'émetteur du transistor T10. La borne φ2 est reliée par une résistance R11 à l'émetteur du transistor T2, ainsi qu'à l'émetteur du transistor T9. Les bases des transistors T2 et T10 sont reliées entre elles. Il en est de même des bases des transistors T1 et T9.

Des diodes D1 et D2 sont montées entre l'émetteur et la base des transistors T1 et T2 pour protéger lesdits transistors contre l'inversion de polarité des jonctions émetteur-base.

Les collecteurs des transistors T1, T10, T9 et T2 sont reliés aux collecteurs de transistors PNP T7, T5, T6 et T8 dont les bases sont reliées entre elles et dont les émetteurs sont reliés à une ligne d'alimentation sous une tension UB+ elle-même reliée au pôle positif de la batterie du véhicule.

Par ailleurs, le circuit comporte deux bornes de sortie logique S1 et S2.

La borne S1 est reliée au collecteur d'un transistor PNP T3, dont la base est reliée aux collecteurs des transistors T1 et T7. L'émetteur de ce transistor T3 est relié à la ligne UB+. La borne de sortie logique S1 est par ailleurs reliée à la masse par l'intermédiaire d'une résistance R9. De la même façon, la borne S2 est reliée au collecteur d'un transistor PNP T4, dont la base est reliée aux collecteurs des transistors T2 et T8 tandis que son émetteur est relié à la ligne UB+. La borne de sortie logique S2 est elle-même reliée à la masse-par l'intermédiaire d'une résistance R12.

On notera que les résistances R9 et R12 ne font pas partie du détecteur proprement dit : elles servent de résistances de charge des étages de sortie du détecteur constitués par les transistors T3 et T4.

Egalement, le circuit de détection représenté sur la figure 2 comporte un générateur de courant G. Ce générateur G comprend une résistance R5 de forte valeur montée entre la ligne UB+ et la base d'un transistor T11 NPN. Ladite base du transistor T11 est reliée à la masse par l'intermédiaire de deux diodes D3 et D4 de compensation thermique en série avec une diode zener DZ1. L'émetteur du transistor T11 est relié à la masse par l'intermédiaire d'une résistance R3, ainsi que par l'intermédiaire d'un sous circuit qui comporte en série une résistance R4 et un transistor M1 de type MOSFET, dont la commande sera explicitée plus loin de façon détaillée.

Le collecteur et la base du transistor T11 sont reliés respectivement aux collecteurs des transistors T13 et T12 de type PNP montés en miroir de courant. Les bases des transistors T12 et T13 sont reliées aux bases des transistors T5 à T8, tandis que leurs émetteurs sont reliés à la ligne UB+.

Comme on l'aura compris, ce mode de réalisation reprend des éléments du détecteur décrit dans FR 2.678.070. On y retrouve les transistors T1, T2, T3, T4 et les résistances R10 et R11. Les résistances R7 et R8 y sont remplacées par les transistors T7 et T8 fonctionnant en source de courant.

Comme le détecteur décrit dans FR-2.678.070, le détecteur représenté sur la figure 2 ne comporte pas de potentiel de masse et les entrées phases φ1 et φ2 peuvent avoir toutes les valeurs inférieures au potentiel U_{B}⁺ sans affecter le niveau de détection (lequel est préférentiellement de l'ordre de 200 mV).

La résistance R6 sert à polariser l'induit de l'alternateur lorsque celui-ci est à l'arrêt. La valeur de cette résistance R6 est suffisamment forte pour ne pas empêcher l'application du potentiel fortement négatif sur les entrées phases φ1 et φ2 (- 10 volts par rapport à la masse).

Le détecteur DP fonctionne de la façon suivante : le transistor T11 délivre un courant (20 µA) calibré par la résistance R3 et les diodes D3, D4 et DZ1. Les diodes D3 et D4 compensent thermiquement la jonction émetteur-base de T11 et la tension zener de DZ1.

On suppose dans un premier temps que le transistor M1 est ouvert.

Le courant délivré par le transistor T11 est recopié dans un rapport 1 (20 µA) par les transistors T12, T7 et T8, et dans un rapport 1/2 (10 µA) par les transistors T5 et T6.

Les miroirs de courant que constituent les couples de transistors T9 et T1 d'une part, et T10 et T2 d'autre part, recopient les courants issus de T6 et T5 (10 µA). Ces miroirs maintiennent des potentiels identiques, sinon voisins, aux points E1 et E2 (émetteurs de T10 et T1 d'une part, émetteurs de T9 et T2 d'autre part).

Lorsque l'alternateur est à l'arrêt, les deux branches du détecteur sont à l'équilibre puisque le potentiel de la phase φ2 est identique au potentiel de la phase φ1. Par symétrie, T1 recopie le courant dans T9 (10 µA) et T2 recopie le courant dans T10 (10µA).

En conséquence, les transistors T7 et T8 saturent car ils ne peuvent délivrer 20 µA, et les transistors T3 et T4 sont ouverts. Les sorties S1 et S2 du détecteur sont donc portées au potentiel de masse.

Par contre, lorsque l'alternateur est en rotation, la f.e.m. entre φ1 et φ2 déséquilibre les deux branches du détecteur et les courants dans T1 et T2 ne sont plus fixés à 10 µA. Si le potentiel de φ1 décroît par rapport au potentiel de φ2, le courant dans R10 et T1 augmente et passe de 10 µA à 20µA. Si ce courant dépasse 20 µA, le transistor T7 déssature et la base de T3 est alimentée. T3 est alors passant et le potentiel de S1 est positif par rapport à la masse. De même, si le potentiel de φ2 décroît par rapport au potentiel de φ1, le potentiel de S2 devient positif par rapport à la masse à partir du seuil où le courant dans T2 dépasse 20 µA.

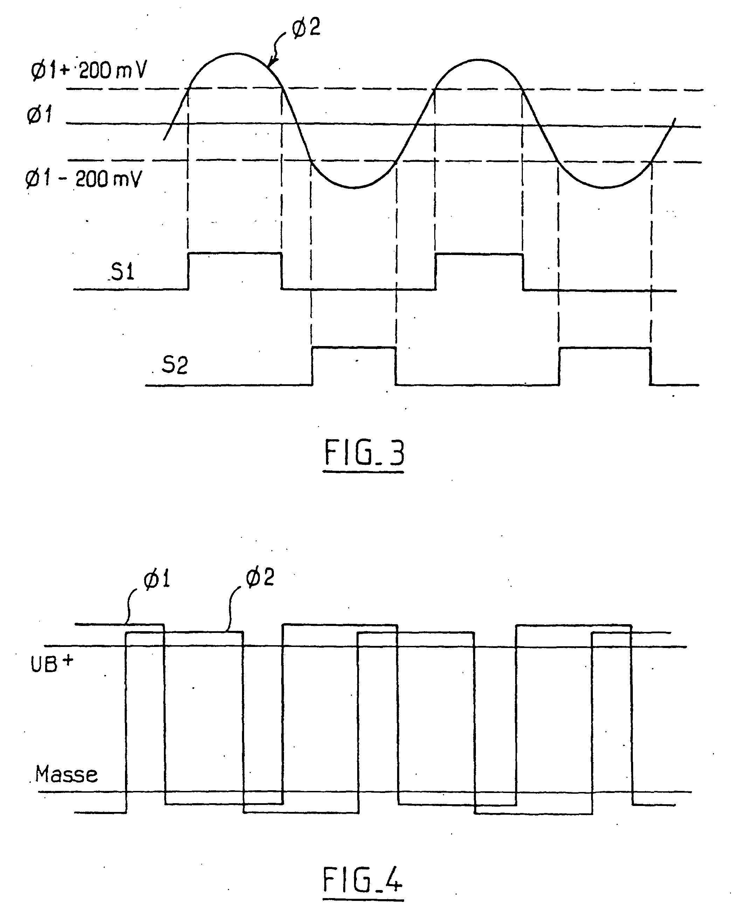

La figure 3 représente la variation de tension sur les sorties S1 et S2 lorsque le potentiel de φ2 varie d'une façon sinusoïdale par rappart à φ1. Ceci correspond à la f.e.m. produite par la rémanence du circuit magnétique de l'inducteur lorsque l'alternateur entre en rotation.

Le niveau de détection d'une différence de potentiels entre les bornes φ2 et φ1 est préférentiellement de l'ordre de 200 mV. On démontre que cette sensibilité de détection est obtenue pour des valeurs des résistances R10 et R11 choisies égales à 10 KΩ.

Ce niveau de détection de 200 mV entre phases permet l'auto-amorçage de l'alternateur à basse vitesse de rotation (< 1000 tours/mn) sans courant d'excitation initial.

Toutefois, une telle sensibilité peut provoquer une mauvaise mise en forme des signaux phases en sortie S1 et S2 lorsque l'alternateur débite. Dans ce cas, la f.e.m. entre φ1 et φ2 n'est plus sinusoïdale, mais est, ainsi que l'illustre la figure 4, rectangulaire. En particulier, lorsque les deux diodes de redressement négatives (reliées à φ1 et φ2) sont passantes en même temps, la différence de potentiel entre φ1 et φ2 est théoriquement nulle. En pratique, les dispersions des diodes et les variations de courant dans ces diodes font que des variations de 200 mV sont possibles entre φ1 et φ2 dans la zone où la différence de potentiel entre φ1 et φ2 est théoriquement nulle. Les signaux obtenus en S1 et S2 ne correspondent pas à des fronts de commutation des diodes, et il n'est pas possible de mesurer la période des signaux phases.

La solution consiste à augmenter le niveau de détection lorsque la f.e.m. entre φ1 et φ2 est élevée, tout en restant inférieure à toute possibilité de charge : par exemple, le changement de niveau de détection peut passer de 200 mV à 800 mV lorsque la f.e.m. entre phases dépasse 7 volts. Cette mesure de f.e.m. peut être réalisée par le circuit de régulation du signal phase déjà utilisé dans beaucoup de régulateurs dit "multifonction".

Le générateur de courant G permet de réaliser ce changement de niveau de détection. Lorsque le régulateur détecte une amplitude des signaux entre phases supérieure à 7 volts, il rend passant le transistor M1, de sorte que la résistance R4 est mise en parallèle sur R3. En conséquence, l'augmentation de courant dans T11, T5, T6, T7, T8 entraîne l'augmentation du niveau de détection recherché : on obtient un niveau de détection de 800 mV pour des courants de 100 µA dans T11, T7 et T8 et 50 µA dans T5 et T6.

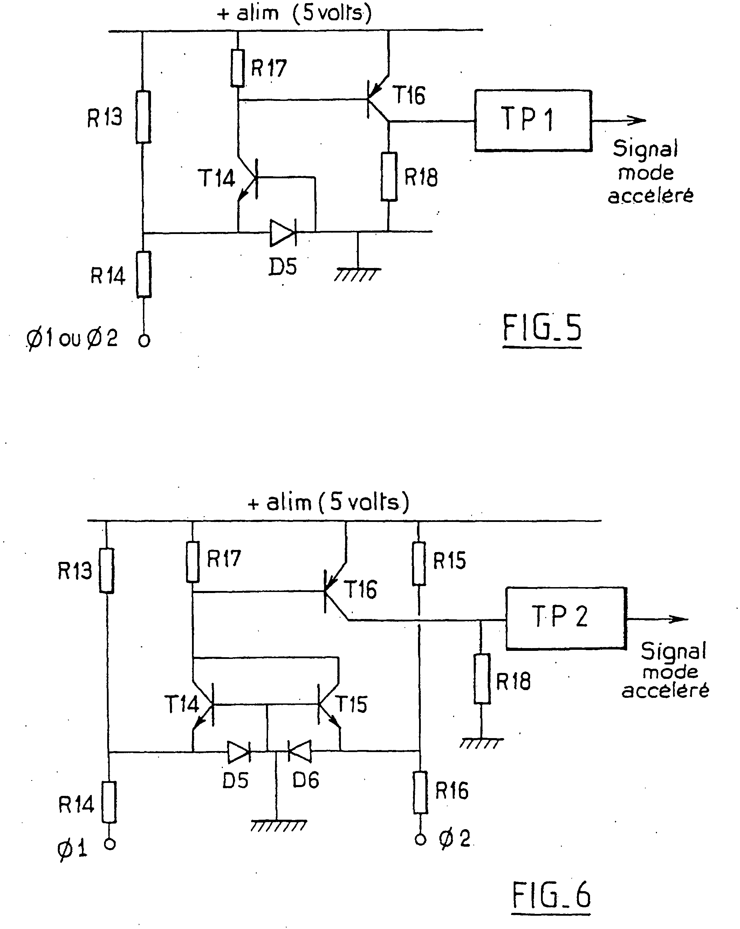

On a représenté sur la figure 5 un exemple de réalisation possible pour le circuit ACC. Le circuit représenté sur cet exemple comporte des moyens de temporisation TP1 qui sont activés par la réception sur l'une des bornes φ1 ou φ2 d'une tension inférieure à un seuil donné par rapport à la masse.

A cet effet, des moyens formant diviseur potentiomètrique sont interposés entre lesdites bornes d'entrée et les moyens de temporisation TP1. Ces moyens sont constitués par deux résistances R13 et R14 dont le point commun est relié à l'émetteur d'un transistor T14 NPN dont la base est reliée à la masse et dont le collecteur est relié par l'intermédiaire d'une résistance R17 à une ligne d'alimentation d'une tension de 5 volts. La résistance R13 est montée entre ladite ligne et ledit émetteur. La résistance R14 est montée entre ledit émetteur et l'une des bornes φ1 et φ2.

Une diode D5 est montée entre ledit émetteur et la masse pour protéger la jonction émetteur base de T14.

Un transistor PNP T16 est monté entre la ligne d'alimentation et la masse. Plus précisément, la base de ce transistor T16 est commandée par le collecteur du transistor T14 ; son émetteur est relié à la ligne d'alimentation ; son collecteur est relié à la masse par une résistance R18. Sa tension de collecteur est en outre injectée sur l'entrée des moyens de temporisation TP1.

Ce diviseur potentiomètrique R13-R14 rend passant le transistor T14 et donc le transistor T16 lorsque le potentiel de la phase φ1 ou φ2 dépasse un niveau prédéterminé (par exemple - 5 volts).

Les moyens de temporisation TP1 mémorisent le signal de passage en mode accéléré, au moins jusqu'à l'alternance suivante de φ1 ou φ2.

Un autre exemple de réalisation possible est encore illustré sur la figure 6. Dans cet exemple, un circuit de temporisation TP2 est commandé indifféremment par le niveau de potentiel sur les deux entrées de phase φ1 et φ2. A cet effet, le diviseur potentiomètrique R13-R14 et le transistor T14 qui commandent le transistor 16 ont été doublés par un deuxième diviseur potentiomètrique R15-R16 et un deuxième transistor T15. Des diodes D5 et D6 protègent les jonctions émetteur-base des transistors T14 et T15 contre les polarités inverses.

Ainsi, la temporisation qui commande le fonctionnement en mode accéléré est déclenchée dès que le potentiel sur φ1 ou le potentiel sur φ2 passe en dessous du seuil précité (-5 volts, par exemple). Si les signaux appliqués sur φ1 et φ2 sont rigoureusement en opposition de phase (ce qui est facilement réalisable pendant le test), la temporisation TP2 peut être facilement réduite.

Bien entendu, ce mode de fonctionnement, déclenché par des potentiels fortement négatifs sur les bornes φ1 et φ2 ne peut se produire sur un régulateur monté sur un alternateur car le pont redresseur P limite à - 1 volt le potentiel de φ1 et φ2.

Le fonctionnement en mode accéléré ne peut être obtenu que lors de tests sur le régulateur seul ou monté sur un porte-balais.

D'autres variantes de réalisation de l'invention sont bien entendu envisageables.

Notamment, au lieu d'être déclenché par un potentiel fortement négatif, le mode accéléré pourrait être déclenché par la présence d'alternances à un potentiel supérieur à la tension de la batterie sur les bornes φ1 et φ2.

## Revendications

1. Régulateur d'alternateur polyphasé de véhicule automobile comportant d'une part des moyens (DP) pour détecter une tension entre des bornes de phase destinées à recevoir des potentiels de phase dudit alternateur et d'autre part des moyens pour détecter un signal de déclenchement d'un fonctionnement en mode accéléré, **caractérisé en ce que** les moyens (ACC) de détection du signal de déclenchement comportent des moyens pour détecter un niveau particulier de potentiel ou d'intensité de courant sur au moins une borne de phase (φ1 et φ2), ainsi que des moyens pour déclencher un fonctionnement en mode accéléré lorsque ce niveau de tension ou d'intensité de courant est détecté et **en ce que** les moyens (DP) pour la détection d'une tension entre les bornes de phase sont aptes à détecter ladite tension avec ce niveau d'intensité ou de potentiel sur la borne de phase précitée.

2. Régulateur selon la revendication 1, **caractérisé en ce que** les moyens (ACC) de détection du signal de déclenchement comportent des moyens pour détecter un niveau de tension particulier sur les crêtes d'au moins un potentiel reçu sur une borne de phase.

3. Régulateur selon la revendication 2, **caractérisé en ce que** lesdits moyens (ACC) de détection comportent des moyens pour détecter que les crêtes des alternances négatives dudit potentiel sont inférieures à un seuil de potentiel en dessous du potentiel de masse:

4. Régulateur selon la revendication 3, **caractérisé en ce que** ledit seuil de potentiel est de l'ordre de 10 volts en dessous du potentiel de masse.

5. Régulateur selon la revendication 2, **caractérisé en ce que** lesdits moyens (ACC) de détection du signal de déclenchement comportent des moyens pour détecter que les crêtes des alternances positives d'un potentiel reçu sur une borne de phase sont supérieures à un seuil au-dessus de la tension de la batterie.

6. Régulateur selon l'une des revendications précédentes, **caractérisé en ce que** les moyens (DP) de détection d'une tension entre des bornes de phases (φ1 et φ2) comportent un montage de transistors (T1, T9 ; T2, T10) formant miroir de courant dont deux branches sont alimentées par des montages de transistors (T6, T7 ; T5, T8) formant sources de courant d'intensités différentes, l'un (T7, T8) des transistors de ces montages formant sources de courant se limitant à une valeur de courant prédéterminée (20µA) lorsqu'une différence de potentiel apparaît entre les deux bornes de phase, cette limitation entraînant le changement de niveau d'une sortie logique (S1, S2).

7. Régulateur selon la revendication 6 **caractérisé en ce que** le niveau de détection de la tension entre phases est lié à la différence d'intensité des sources de courant (T6 et T7 d'une part, T5 et T8 d'autre part) des moyens de détection.

8. Régulateur selon la revendication 6 ou 7, **caractérisé en ce qu'**il comporte deux sorties logiques et **en ce que** lesdits montages (T1, T9 ; T2, T10 ; T6, T7 ; T5, T8) de transistors formant miroir et sources de courant sont dédoublés pour entraîner le changement de niveau de l'une ou l'autre desdites sorties logiques selon le sens de la différence de potentiel entre les bornes de phase.

9. Régulateur selon l'une des revendications 6 à 8, **caractérisé en ce que** le niveau de détection que permettent lesdits moyens est de l'ordre de 200 mV.

10. Régulateur selon la revendication 9, **caractérisé en ce qu'**il comporte des moyens (M1, R4) pour modifier le niveau de détection de la tension entre les bornes de phase lorsque le potentiel reçu sur lesdites bornes est supérieur à une valeur donnée.

11. Régulateur selon l'une quelconque des revendications précédentes, **caractérisé en ce que** les moyens (ACC) pour déclencher le fonctionnement en mode accéléré comportent un circuit de temporisation monté en sortie des moyens de détection du niveau de tension ou d'intensité de courant.

## Claims

1. A regulator for a polyphase alternator for a motor vehicle, the regulator including detector means (DP) for detecting a voltage difference between the phase terminals that are to receive the phase voltages from said alternator, and means for detecting a trigger signal for triggering operation in an accelerated mode, the regulator being **characterized in that** the means (ACC) for detecting a trigger signal comprise means for detecting a particular level of the voltage or current on at least one of the phase terminals (φ1 and φ2), and means for triggering accelerated mode operation when said voltage or current level is detected, and **in that** the detector means (DP) for detecting a voltage difference between the phase terminals are suitable for detecting said voltage difference at the said current or voltage level on said phase terminal.

2. A regulator according to claim 1, **characterized in that** the means (ACC) for detecting the trigger signal comprise means for detecting a particular voltage level in the peaks, at least of the voltage received on a phase terminal.

3. A regulator according to claim 2, **characterized in that** said means (ACC) for detecting the trigger signal include means for detecting that the peaks of the negative half-cycles of said voltage are below a voltage threshold below ground potential.

4. A regulator according to claim 3, **characterized in that** said voltage threshold is about 10 volts below ground potential.

5. A regulator according to claim 2, **characterized in that** said means (ACC) for detecting the trigger signal comprise means for detecting that the peaks of the positive half-cycles of a voltage received on a phase terminal are greater than a threshold above battery voltage.

6. A regulator according to any preceding claim, **characterized in that** the means (DP) for detecting a voltage difference between the phase terminals (φ1 and φ2) comprise a transistor circuit (T1, T9; T2, T10) forming a current mirror whose two branches are fed by transistor circuits (T6, T7; T5, T8) forming current sources of different currents, one of the transistors (T7, T8) of these current source circuits being limited to a predetermined current value (20 µA) when a voltage difference appears between the two phase terminals, said limitation causing a voltage output (S1, S2) to change level.

7. A regulator according to claim 6, **characterized in that** the level at which a voltage difference is detected between the phases is tied to the current difference between the current sources (T6 & T7, T5 & T8) of the detector means.

8. A regulator according to claim 6 or 7, **characterized in that** it has two logic outputs and **in that** said transistor circuits (T1, T9; T2, T10, T6, T7; T5, T8) forming a current mirror and current sources are duplicated to cause one or the other of said logic outputs to change level depending on the sign of the voltage difference between the phase terminals.

9. A regulator according to any one of claims 6 to 8, **characterized in that** the detection threshold level made possible by said means is about 200 mV.

10. A regulator according to claim 9, **characterized in that** it includes means (M1, R4) for modifying the detection threshold level for the voltage difference between the phase terminals when the voltage received on said terminals is greater than a given value.

11. A regulator according to any preceding claim, **characterized in that** the means (ACC) for triggering accelerated mode operation include a time delay circuit connected to the output of means for detecting the voltage or a current level.

## Patentansprüche

1. Mehrphasiger Generatorregler für ein Kraftfahrzeug, der einerseits Mittel (DP) zur Erfassung einer Spannung zwischen Phasenklemmen, die dazu bestimmt sind, Phasenpotentiale des besagten Generators zu empfangen, und andererseits Mittel umfaßt, um ein Auslösesignal zum Auslösen eines Betriebs im beschleunigten Modus zu erfassen, **dadurch gekennzeichnet, daß** die Mittel (ACC) zur Erfassung des Auslösesignals Mittel, um einen besonderen Potential- oder Stromstärkepegel an wenigstens einer Phasenklemme (φ1 und φ2) zu erfassen, sowie Mittel umfassen, um einen Betrieb im beschleunigten Modus auszulösen, wenn dieser Potential- oder Stromstärkepegel erfaßt wird, und daß die Mittel (DP) zur Erfassung einer Spannung zwischen den Phasenklemmen geeignet sind, die besagte Spannung mit diesem Stromstärke- oder Potentialpegel an der vorgenannten Phasenklemme zu erfassen.

2. Regler nach Anspruch 1, **dadurch gekennzeichnet, daß** die Mittel (ACC) zur Erfassung des Auslösesignals Mittel umfassen, um einen besonderen Spannungspegel an den Spitzen wenigstens eines an einer Phasenklemme empfangenen Potentials zu erfassen.

3. Regler nach Anspruch 2, **dadurch gekennzeichnet, daß** die besagten Erfassungsmittel (ACC) Mittel umfassen, um zu erfassen, daß die Spitzen der negativen Halbperioden des besagten Potentials niedriger als ein Potentialschwellenwert unterhalb des Massepotentials sind.

4. Regler nach Anspruch 3, **dadurch gekennzeichnet, daß** der besagte Potentialschwellenwert in einer Größenordnung von 10 Volt unterhalb des Massepotentials liegt.

5. Regler nach Anspruch 2, **dadurch gekennzeichnet, daß** die besagten Erfassungsmittel (ACC) Mittel umfassen, um zu erfassen, daß die Spitzen der positiven Halbperioden eines an einer Phasenklemme empfangenen Potentials höher als ein Schwellenwert oberhalb der Batteriespannung sind.

6. Regler nach einem der vorangehenden Ansprüche, **dadurch gekennzeichnet, daß** die Mittel (DP) zur Erfassung einer Spannung zwischen Phasenklemmen (φ1 und φ2) eine als Stromspiegel dienende Transistorenschaltung (T1, T9; T2, T10) umfassen, von der zwei Stränge durch als Stromquellen mit unterschiedlichen Stromstärken dienende Transistorenschaltungen (T6, T7; T5, T8) gespeist werden, wobei einer (T7, T8) der Transistoren dieser als Stromquellen dienenden Schaltungen sich auf einen vorbestimmten Stromwert (20 µA) begrenzt, wenn ein Potentialunterschied zwischen den beiden Phasenklemmen auftritt, wobei diese Begrenzung die Pegeländerung eines logischen Ausgangs (S1, S2) zur Folge hat.

7. Regler nach Anspruch 6, **dadurch gekennzeichnet, daß** der Erfassungspegel zur Erfassung der Spannung zwischen den Phasen mit dem Stromstärkeunterschied der Stromquellen (T6 und T7 einerseits, T5 und T8 andererseits) der Erfassungsmittel zusammenhängt.

8. Regler nach Anspruch 6 oder 7, **dadurch gekennzeichnet, daß** er zwei logische Ausgänge umfaßt und daß die besagten als Stromspiegel und als Stromquelle dienenden Transistorschaltungen (T1, T9; T2, T10; T6, T7; T5, T8) gedoppelt sind; um die Pegeländerung des einen oder des anderen der besagten logischen Ausgänge je nach der Richtung des Potentialunterschieds zwischen den Phasen klemmen herbeizuführen.

9. Regler nach einem der Ansprüche 6 bis 8, **dadurch gekennzeichnet, daß** der Erfassungspegel, den die besagten Mittel ermöglichen, in der Größenordnung von 200 mV liegt.

10. Regler nach Anspruch 9, **dadurch gekennzeichnet, daß** er Mittel (M1, R4) umfaßt, um den Erfassungspegel zur Erfassung der Spannung zwischen den Phasenklemmen zu ändern, wenn das an den besagten Klemmen empfangene Potential größer als ein gegebener Wert ausfällt.

11. Regler nach einem der vorangehenden Ansprüche, **dadurch gekennzeichnet, daß** die Mittel (ACC) zum Auslösen des Betriebs im beschleunigten Modus eine Verzögerungsschaltung umfassen, die am Ausgang der Erfassungsmittel zur Erfassung des Spannungs- oder Stromstärkepegels geschaltet ist.
